# EUROPÄISCHE PATENTSCHRIFT

(11) **EP 0 818 688 B1**
(45) Veröffentlichungstag und Bekanntmachung des Hinweises auf die Patenterteilung: **17.03.2004**
(21) Anmeldenummer: 97202053.1
(22) Anmeldetag: 03.07.1997
(51) Int. Cl.: G01R 33/38

(54) **MR-Anordnung**
MR apparatus
Appareil de résonance magnétique

(30) Priorität: 13.07.1996 DE 19628363
(43) Veröffentlichungstag der Anmeldung: 14.01.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Overweg, Johannes A., Dr., Röntgenstrasse 24, 22335 Hamburg (DE)
(74) Vertreter: Volmer, Georg, Dipl.-Ing.

(56) Entgegenhaltungen:
- EP-A- 0 609 604
- DE-A- 4 417 940
- US-A- 5 250 901
- US-A- 5 412 363

## Beschreibung

Die Erfindung betrifft eine Magnetresonanz (MR)-Anordnung nach dem Oberbegriff des Anspruchs 1 bekannt.

Die darin vorgesehenen Jochplatten, die Jochwand, der Polblock und die Spule bilden zusammen die Grundfeldmagnetanordnung, die ein homogenes stationäres Magnetfeld erzeugt. Die Jochplatten, die Jochwand und der Polblock umschließen einen Innenraum und leiten den von der im Innenraum angeordneten Spule erzeugten Magnetfluß. Die Jochplatten, die Jochwand und der Polblock bestehen aus magnetisierbarem Material, beispielsweise Eisen oder Stahl und bieten deshalb einen geringen magnetischen Widerstand für den Magnetfluß.

Eine MR-Anordnung der eingangs genannten Art ist aus der DE-A 44 17 940 im wesentlichen bekannt; allerdings ist dort oberhalb und unterhalb des Untersuchungsbereiches je ein Polstück vorgesehen. Die dort supraleitende Spule ist an einem zwischen der oberen Jochplatte und dem Untersuchungsbereich befindlichen Polstück angeordnet. Weiterhin befindet sich zwischen diesem Polstück und dem Untersuchungsbereich eine Kollimatorplatte. In dem Luftspalt zwischen der Kollimatorplatte und dem unterhalb des Untersuchungsbereichs angeordneten Polblock liegt der Patient während der Untersuchung auf einem Patiententisch. Die Kollimatorplatte dient dazu, das stationäre Grundmagnetfeld im Untersuchungsbereich, in dem sich der abzubildende Teil des Patienten befindet, möglichst homogen zu gestalten. Da sich die Kollimatorplatte in geringem Abstand oberhalb des Patienten befindet, ist der Patient dort allerdings nur von den Seiten aus beispielsweise für gleichzeitig zur MR-Untersuchung stattfindende Behandlungen zugänglich.

Weiterhin ist aus der EP-A-0 609 604 eine ähnliche MR-Anordnung bekannt, bei der ebenfalls oberhalb und unterhalb des Untersuchungsbereiches je ein Polstück vorgesehen ist. Das untere Polstück wird von einer supraleitenden Spule umschlossen. Das obere Polstück behindert den freien Zugang zum Untersuchungsbereich von oben, während, die supraleitenden Spule den freien Zugang von der Seite beeinträchtigt.

Moderne MR-Abbildungsverfahren ermöglichen es, MR-Bilder in Echtzeit zu erstellen. Dies kann vor allem bei interventionellen Anwendungen benutzt werden, um beispielsweise dem Arzt während einer Operation ständig aktuelle MR-Bilder zu liefern oder bei minimal- oder nicht-invasiven Techniken den Fortschritt der Behandlung laufend aktuell darzustellen.

Der vorliegenden Erfindung liegt die Aufgabe zugrunde, eine MR-Anordnung der eingangs genannten Art zu verbessern.

Diese Aufgabe wird erfindungsgemäß dadurch gelöst, daß die Spule ringförmig ausgestaltet ist und im wesentlichen den Untersuchungsbereich im wesentlichen umschließt derart, daß ein im Untersuchungsbereich befindlicher Patient seitlich und von oben frei zugänglich ist.

Die Erfindung geht dabei von der Erkenntnis aus, daß zur Erreichung einer ausreichend großen Magnetfeldhomogenität im Untersuchungsbereich der Magnetfluß nicht aktiv von einem magnetischen Bauteil direkt oberhalb und unterhalb des Abbildungsbereichs geleitet werden muß, sondern daß die nötige Magnetfeldhomogenität auch durch Vergrößern des Durchmessers der Spule erreicht werden kann.

Eine ausreichende Magnetfeldhomogenität wird bei der erfindungsgemäßen MR-Anordnung im wesentlichen durch den gegenüber der bekannten MR-Anordnung deutlich größeren Durchmesser der Spule und die ringförmige Ausgestaltung der Spule um den Untersuchungsbereich erreicht. Die bei der bekannten MR-Anordnung direkt oberhalb des Patienten befindliche Kollimatorplatte kann deshalb hier entfallen. Außerdem ist die Spule bei der erfindungsgemäßen MR-Anordnung nicht an einem mit der oberen Jochplatte verbundenen Polstück angeordnet. Innerhalb der Spule und zwischen der Spule und dem Patienten befinden sich also keine weiteren Bauteile der Grundfeldmagnetanordnung. Dies ermöglicht den nahezu ungehinderten Zugang zum Patienten von den Seiten und von oben, wobei sich ein oder mehrere Ärzte bei Behandlung des Patienten während der MR-Untersuchung im von den Jochplatten und der Jochwand umschlossenen Innenraum und innerhalb des Spulendurchmessers befinden.

In der Erfindung ist vorgesehen, daß der Durchmesser der Spule mindestens zwei Meter beträgt. Je größer der Durchmesser der Spule ist, desto größer ist der Untersuchungsbereich, d.h., desto größer ist der Bereich, in dem das Magnetfeld eine zur Erstellung von MR-Abbildungen ausreichende Feldhomogenität aufweist. Bei einem größeren Spulendurchmesser haben außerdem mehr Personen Zugang zum Patienten und können sich ungehinderter bewegen. Andererseits begrenzen die Kosten den Durchmesser der Spule nach oben hin. Ein Kompromiß zwischen ausreichender Magnetfeldhomogenität, großer Bewegungsfreiheit der den Patienten behandelnden Personen und Zugänglichkeit des Patienten einerseits und den Kosten andererseits liegt bei einem Durchmesser der Spule im Bereich von zwei bis vier Metern.

In einer Ausgestaltung ist erfindungsgemäß vorgesehen, daß der Abstand zwischen der horizontalen Mittelebene der Spule und der Oberseite des Polblocks etwa dem halben Radius der Spule entspricht. Unterhalb des Untersuchungsbereichs stellt sich ein Magnetfeld ein, das spiegelbildlich - gespiegelt an der horizontal verlaufenden Ebene, in der die obere Abschlußfläche des Polblocks liegt - ist zum oberhalb des Untersuchungsbereichs von der Spule erzeugten Magnetfeld so, als wäre unterhalb des Untersuchungsbereichs eine weitere Spule vorhanden. Es ergibt sich also im Untersuchungsbereich näherungsweise das Magnetfeld eines Helmholtz-Spulenpaares, welches seine beste Feldhomogenität erreicht, wenn der Abstand zwischen den Spulen etwa so groß ist wie der Spulenradius. Durch die erfindungsgemäße Wahl des Abstandes zwischen der horizontalen Mittelebene der Spule und der Oberseite des Polblocks wird also zusätzlich zur Erhöhung der Feldhomogenität im Untersuchungsbereich beigetragen.

In einer vorteilhaften Ausgestaltung der Erfindung ist vorgesehen, daß der Durchmesser des Polblocks etwa das Dreifache des Durchmessers des Untersuchungsbereichs beträgt. Soll beispielsweise der Kopf des Patienten vollständig abgebildet werden, so wird bei einem Durchmesser des Polblocks von etwa 90 cm in einem Untersuchungsbereich mit einem Durchmesser von etwa 30 cm eine ausreichende Feldhomogenität erreicht.

Eine weitere Ausgestaltung der erfindungsgemäßen MR-Anordnung sieht vor, daß die obere Jochplatte eine zentrale Öffnung aufweist, insbesondere zum Einbringen weiterer Geräte in den Innenraum. Weitere Geräte können beispielsweise Geräte zur Strahlentherapie sein, wobei dann bei der erfindungsgemäßen MR-Anordnung der Fortschritt der Strahlentherapiebehandlung in Echtzeit überwacht werden kann. Durch die zentrale Öffnung kann beispielsweise auch ein außerhalb des Innenraums an der Decke angebrachter, an einem beweglichen Arm befindlicher Röntgenapparat in den Innenraum eingebracht werden, mit dem gleichzeitig während der MR-Untersuchung Röntgenbilder aufgenommen werden können. Auch zu Beleuchungszwecken kann die zentrale Öffnung dienen, indem durch sie Beleuchtungsmittel, die beispielsweise an der Decke angebracht sind, in den Innenraum eingebracht werden können oder zumindest den Innenraum beleuchten.

Eine bevorzugte Weiterbildung sieht erfindungsgemäß vor, daß die Jochwand aus mehreren voneinander beabstandeten und in gleichen Abständen vom Untersuchungsbereich angeordneten Eisenpfeilern besteht. Die gleichen Abstände und die möglichst gleiche Ausgestaltung der Eisenpfeiler ist erforderlich, damit das Magnetfeld möglichst im zentralen Bereich des Innenraums die größte Homogenität aufweist, in dem der Untersuchungsbereich liegt. Die Abstände zwischen den Eisenpfeilern sind dabei derart groß gewählt, daß der Patient in den Innenraum transportiert werden kann und daß das Behandlungspersonal den Innenraum auf einfache Weise betreten kann.

In einer weiteren Ausgestaltung der Erfindung ist vorgesehen, daß der Polblock eine zentral im Innern in vertikaler Richtung verlaufende Bohrung aufweist. Durch den Durchmesser der Bohrung kann eingestellt werden, wieviel Magnetfluß vom Polblock geleitet wird. Dadurch wird letztlich ebenfalls die Homogenität des Magnetfeldes im Untersuchungsbereich beieinflußt.

Eine bevorzugte Ausgestaltung der Erfindung sieht vor, daß die Spule supraleitende Eigenschaften aufweist, wodurch ein besonders starkes und homogenes Magnetfeld erzeugt werden kann.

Die Erfindung wird nachfolgend anhand der Zeichnung näher erläutert. Es zeigen:
- Fig. 1: einen Querschnitt durch eine Ausgestaltung der erfindungsgemäßen MR-Anordnung und
- Fig. 2: eine Draufsicht auf die MR-Anordnung gemäß Fig. 1.

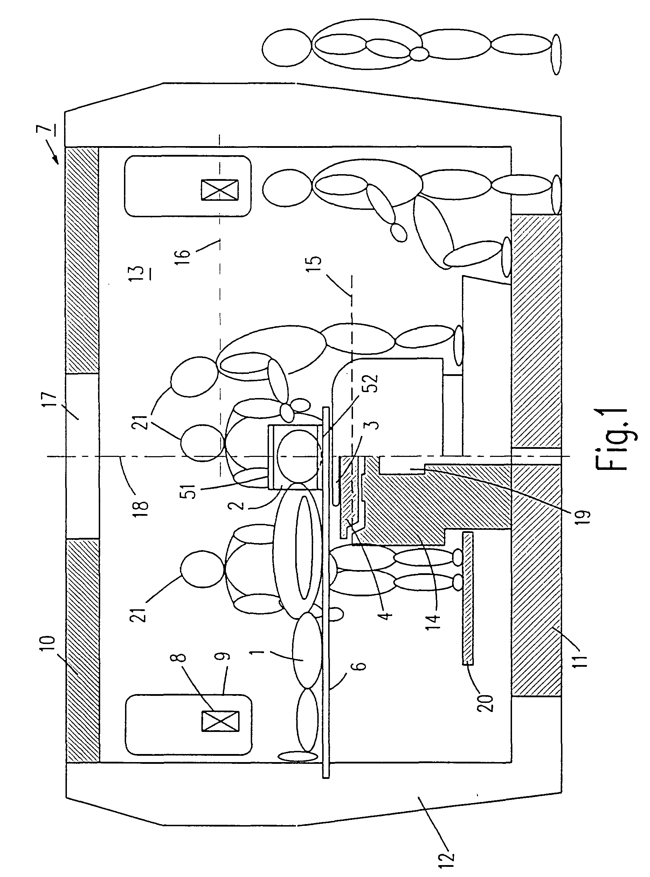

In Fig. 1 ist mit 1 ein Patient bezeichnet, der sich im Innenraum 13 einer erfindungsgemäßen MR-Anordnung auf einem Patiententisch 6 liegend befindet. Der Patient 1 befindet sich hier in einer Position zur Untersuchung des Kopfes, in der der Kopf auf der vertikal verlaufenden Symmetrieachse 18 der MR-Anordnung im Untersuchungsbereich 2 angeordnet ist. Unterhalb des Kopfes des Patienten 1 befindet sich eine Sendespulenanordnung 3, die im Untersuchungsbereich 2 impulsweise ein hochfrequentes Magnetfeld erzeugen kann. Darunter befindet sich eine aus mehreren Gradientenspulen bestehende Gradientenspulenanordnung 4, die magnetische Gradientenfelder erzeugt, die in Richtung der vertikalen Achse 18 verlaufen und von einem Gradienten in einer der drei Raumrichtungen überlagert sind. Als Empfangsspulenanordnung ist hier eine aus zwei Ringspulen 51, 52 bestehende Ringspulenanordnung verwendet, wobei eine Ringspule 51 oberhalb und die zweite Ringspule 52 unterhalb des Kopfes des Patienten 1 angeordnet ist. Mittels der Ringspulen 51, 52, die symmetrisch zur Symmetrieachse 18 angeordnet sind, werden die im Untersuchungsbereich 2 erzeugten MR-Signale detektiert, woraus die Kernmagnetisierungsverteilung im Untersuchungsbereich 2 bestimmt werden kann.

Der Untersuchungsbereich 2 ist einem homogenen stationären Magnetfeld ausgesetzt, das von einer Grundfeldmagnetanordnung 7 erzeugt wird. Diese umfaßt zunächst eine ringförmig ausgestaltete supraleitende Spule 8, die in einem Kryostaten 9 angeordnet ist. Die Spule 8, die als Luftspule ohne Spulenkern ausgestaltet ist, befindet sich oberhalb des Untersuchungsbereichs 2 und ist symmetrisch zur Achse 18 angeordnet so, daß das Magnetfeld im Innern der Spule 8 parallel zur vertikalen Achse 18 ausgerichtet ist. Die Grundfeldmagnetanordnung 7 umfaßt weiterhin eine obere magnetisierbare Jochplatte 10, die oberhalb der Spule 8 angeordnet ist und quasi als Decke der MR-Anordnng dient, sowie eine untere magnetisierbare Jochplatte 11, die in einem Abstand unterhalb des Untersuchungsbereichs 2 angeordnet ist und quasi als Boden der MR-Anordnung dient. Die Grundfeldmagnetanordnung 7 umfaßt außerdem eine die beiden Jochplatten 10 und 11 verbindende, vertikal verlaufende und aus magnetisierbarem Material bestehende Jochwand 12. Diese besteht hier aus mehreren Eisenpfeilern. Die beiden Jochplatten 10 und 11 und die Eisenpfeiler 12 sind symmetrisch zur Achse 18 angeordnet, umschließen die Spule 8, den Patienten 1 und die den Patienten 1 behandelnden Personen 21 und bilden einen Innenraum 13. Sie dienen dazu, den Magnetfluß des von der Spule 8 generierten Magnetfeldes zu führen und die Umgebung der MR-Anordnung von den auftretenden Streufeldern insbesondere der Spule 8 abzuschirmen.

Zwischen der unteren Jochplatte 11 und der Gradientenspulenanordnung 4 befindet sich weiterhin ein symmetrisch zur Achse 18 ausgestalteter Polblock 14, der ebenfalls den Magnetfluß führt und durch spezielle Ausgestaltung die Homogenisierung des Grundmagnetfeldes im Untersuchungsbereich 2 verstärkt.

Zu Beleuchtungszwecken oder zum Einbringen beispielsweise eines an einem Deckenstativ befestigten Röntgengeräts oder eines Strahlentherapiegeräts weist die obere Jochplatte 10 eine zentrale Öffnung 17 auf. Die behandelnden Personen 21 befinden sich im Innenraum 13 auf einem zusätzlichen Innenboden 20 und haben durch die erfindungsgemäße Ausgestaltung der MR-Anordnung Zugang zum Kopf des Patienten 1 von oben und von allen Seiten.

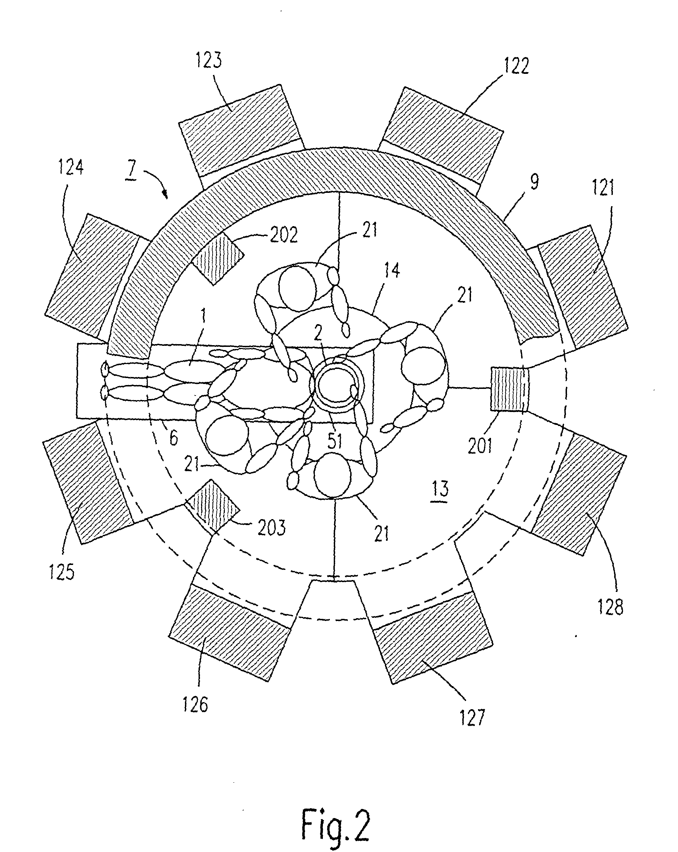

Eine Draufsicht auf die MR-Anordnung gemäß Fig. 1 zeigt Fig. 2. Zu erkennen ist dort insbesondere die rotationssymmetrische Ausgestaltung der Grundfeldmagnetanordnung 7. Zu erkennen ist weiterhin, daß die Jochwand 12 aus acht, den Innenraum 13 umschließenden Eisenpfeilern 121 bis 128 ausgestaltet ist. Durch die Zwischenräume zwischen den Eisenpfeilern können die Ärzte bequem den Innenraum 13 über Eingangstufen 201, 202, 203 betreten.

Die Spule 8 erzeugt ein starkes stationäres homogenes Magnetfeld entlang der Achse 18. Die aus den Jochplatten 10 und 11, der Jochwand 12 und dem Polblock 14 bestehende Jochanordnung dient der Flußrückführung für das Magnetfeld der Spule 8. Das Magnetfeld im Untersuchungsbereich 2 kann als die Summe des von der Spule 8 erzeugten Magnetfeldes und dem von der Jochanordnung bewirkten Beitrag zum Gesamtmagnetfeld angesehen werden. Ohne diese Jochanordnung zur Flußrückführung könnte eine ausreichende Magnetfeldhomogenität im Untersuchungsbereich 2 nicht erreicht werden. Eine Reihe von Parametern beeinflußt bei der gezeigten MR-Anordnung den Verlauf und die Stärke des Magnetfeldes und insbesondere die Größe des Untersuchungsbereichs, dessen Größe davon abhängt, wie groß der Bereich ist, in dem ein zur Erstelleung von MR-Bildern ausreichende Magnetfeldhomogenität vorhanden ist.

Erfindungsgemäß wurde erkannt, daß durch Vergrößern des Spulendurchmessers der Bereich, in dem das stationäre Magnetfeld ausreichend homogen ist, vergrößert werden kann. Im gezeigten Ausführungsbeispiel weist die Spule 8 einen Durchmesser von etwa 3 m auf, bei dem sich einerseits die Ärzte 21 bequem um den Patienten 1 herum bewegen können, die Kosten und das Gewicht der Spule 8 andererseits nicht zu hoch sind. Bei wie nachfolgend beschrieben geeigneter Dimensionierung weiterer Parameter ergibt sich bei diesem Spulendurchmesser ein Untersuchungsbereich mit einem Durchmesser von etwa 400 mm.

Ein weiterer Parameter ist die Zahl der Amperewindungen der Spule 8, durch die die Stärke des Magnetfeldes bestimmt wird. Wegen des nichtlinearen Verhaltens des Polblocks kann das Magnetfeld der Spule nicht beliebig stark gemacht werden. Ab einer Feldstärke von etwa 0,5 Tesla ist das Eisen des Polblocks 14 gesättigt. Oberhalb dieser Feldstärke liefert der Polblock 14 keinen weiteren Beitrag zum effektiven Magnetfeld, das sich aus dem Magnetfeld der Spule und der Jochanordnung zusammensetzt. Von der Spule 8 erzeugte Magnetfeldgradienten niedriger Ordnung können dann nicht mehr durch entsprechende Magnetfeldgradienten des Polblocks kompensiert werden, um insgesamt ein homogenes Magnetfeld im Untersuchungsbereich 2 zu erreichen. Im gezeigten Ausführungsbeispiel ist die Spule 8 derart ausgestaltet, daß das Magnetfeld im Untersuchungsbereich eine Stärke von etwa 1 Tesla aufweist.

Eine weitere Möglichkeit zur Erhöhung der Magnetfeldhomogenität bietet die Ausgestaltung des Polblocks 14. Soll der Magnetfeldanteil der Jochanordnung am Gesamtmagnetfeld verringert werden, so kann dies am einfachsten mittels einer zentralen Bohrung 19 im Polblock 14 erfolgen. Dadurch wird die Größe des von dem Polblock geleiteten Magnetflusses verringert. Je größer der Durchmesser dieser Bohrung 19 gewählt wird, desto geringer wird die Stärke des zentralen Magnetfeldes. Alternativ dazu kann auch der Außendurchmesser insbesondere im unteren Bereich des Polblocks 14 verringert werden. Dadurch können auch die behandelnden Personen 21 bequemer um den Patienten 1 herumstehen. Im dem Untersuchungsbereich 2 benachbarten oberen Bereich des Polblocks darf der Durchmesser allerdings nicht zu klein gewählt sein. Anderenfalls würden Magnetfeldgradienten höherer Ordnung dem Magnetfeld im Zentrum (also dem Untersuchungsbereich 2) überlagert, die von den Randbegrenzungen des Polblocks 14 herrühren, wodurch das Magnetfeld nicht ausreichend homogen wäre. Im gezeigten Beispiel beträgt der Durchmesser des Polblocks 14 etwa 1150 mm, was in etwa dem Dreifachen des Durchmessers des Untersuchungsbereichs 2 entspricht.

Ein weiterer Parameter ist der vertikale Abstand zwischen der Mittelebene 16 der Spule 8 und der oberen Abschlußebene 15 des Polblocks 14. Dieser Abstand ist hier vorteilhaft etwas größer als der halbe Radius der Spule 8 gewählt. Dem liegt die Überlegung zugrunde, daß der Polblock 14 im Untersuchungsbereich 2 im wesentlichen ein Magnetfeld erzeugt, das spiegelbildlich - gespiegelt an der Ebene 15 - zum Magnetfeld der Spule 8 ist und damit quasi eine virtuelle unterhalb des Untersuchungsbereich angeordnete Spule simuliert. Diese virtuelle Spule und die Spule 8 bilden eine Konfiguration ähnlich einem Helmholtz-Spulenpaar, das die beste Feldhomogenität erreicht, wenn der Abstand zwischen den beiden Spulen in etwa dem Spulenradius entspricht.

Auch durch das dem Untersuchungsbereich 2 zugewandte Profil des Polblocks 14 wird die Magnetfeldhomogenität im Untersuchungsbereich 2 beeinflußt. Das Profil ist dabei derart ausgestaltet, daß von der Spule 8 im Untersuchungsbereich erzeugte Magnetfeldgradienten durch Magnetfeldgradienten des Polblocks 14 ausgeglichen werden, um insgesamt ein homogenes Magnetfeld zu erhalten. Dabei muß darauf geachtet werden, daß die Struktur des Polblocks 14 keine Magnetfeldgradienten höherer Ordnung erzeugt, die die Größe des Untersuchungsbereichs 2 begrenzen würden. Für die Ausgestaltung des Profils des Polblocks 14 gibt es eine unendlich große Anzahl von Lösungen, von denen eine vorteilhafte Lösung gezeigt ist, bei der der Rand gegenüber dem zentralen Bereich etwas erhöht ist und etwa ein Drittel des Radius vom Zentrum entfernt ein ringförmiger geringfügig erhöhter Bereich vorhanden ist.

Weitere Parameter, die einen geringeren Einfluß auf den Verlauf des Magnetfelds haben, sind der vertikale Abstand der oberen Jochplatte 10 bzw. der unteren Jochplatte 11 vom Untersuchungsbereich 2, der Durchmesser der zentralen Öffnung 17 in der oberen Jochplatte 10 und das Verhältnis von Höhe zu Breite des Querschnitts der Spule 8. Die Abstände der Jochplatten 10 und 11 zum Untersuchungsbereich 2 sind so gewählt, daß die behandelnden Personen 21 den Innenraum 13 bequem betreten und sich darin frei um den Patienten 1 bewegen können.

Die Anzahl der die Jochwand 12 bildenden Eisenpfeiler 121 bis 128 kann beliebig gewählt werden. Bei geringerer Zahl von Eisenpfeilern wird jedoch bei gleichbleibendem Querschnitt die Magnetfeldinhomogenität erhöht und auch das Streufeld außerhalb der MR-Anordnung wird vergrößert.

Eine weitere Verbesserung der Feldhomogenität kann durch Verwendung weiterer Spulen im Innenraum erreicht werden. Weitere Spulen können ober- oder unterhalb des Patienten angeordnet sein. Zusätzliche Spulen erhöhen jedoch die Komplexität und die Kosten der Grundfeldmagnetanordnung und reduzieren die Zugänglichkeit des Patienten.

Bei der praktischen Ausgestaltung muß insbesondere der Polblock und vor allem dessen dem Untersuchungsbereich zugewandte Oberfläche mit hoher Präzision gefertigt sein, um das vorher durch Simulation berechnete Magnetfeld zu erzeugen. Dennoch kann es erforderlich sein, Herstellungstoleranzen durch geeignete Korrekturelemente auszugleichen. Solche Korrekturelemente können kleine Eisenteile sein, die auf der Oberfläche des Polblocks fest oder beweglich angeordnet sind. Auch speziell geformte kleine Spulen, die in der Umgebung des Untersuchungsbereichs angeordnet werden, können als Korrekturelemente dienen.

Die gezeigte MR-Anordnung könnte auch um 90° gedreht aufgebaut sein, d.h., daß die Jochplatten und die supraleitende Spule senkrecht und die Jochwand und der Polblock horizontal angeordnet sind. Diese Anordnung könnte beispielsweise dazu benutzt werden, MR-Bilder eines stehenden Patienten zu erhalten.

## Patentansprüche

1. MR-Anordnung mit einer in einem Untersuchungsbereich ein stationäres magnetisches Feld erzeugenden Grundfeldmagnetanordnung (7) umfassend
a) eine oberhalb des Untersuchungsbereichs (2) angeordnete, magnetisierbare obere Jochplatte (10),
b) eine unterhalb des Untersuchungsbereichs (2) angeordnete, magnetisierbare untere Jochplatte (11),
c) eine die beiden Jochplatten (10, 11) verbindende, magnetisierbare Jochwand (12), welche zusammen mit den Jochplatten (10, 11) einen Innenraum (13) umschließt,
**gekennzeichnet durch**
d) eine einzige, zwischen dem Untersuchungsbereich (2) und der oberen Jochplatte (10) angeordnete Spule (8) und
e) einen einzigen, zwischen dem Untersuchungsbereich (2) und der unteren Jochplatte (11) angeordneten magnetisierbaren Polblock (14),
und **gekennzeichnet dadurch, daß** die ringförmige Spule (8) einen Durchmesser von wenigstens zwei Metern aufweist und symmetrisch zu einer vertikal durch den Untersuchungsbereich verlaufenden Symmetrieachse (18) angeordnet ist derart, daß ein im Untersuchungsbereich (2) befindlicher Patient (1) seitlich und von oben frei zugänglich ist.

2. MR-Anordnung nach Anspruch 1 oder 2,
**dadurch gekennzeichnet, daß** der Abstand zwischen der horizontalen Mittelebene (16) der Spule (8) und der Oberseite (15) des Polblocks (14) etwa dem halben Radius der Spule (8) entspricht.

3. MR-Anordnung nach einem der vorhergehenden Ansprüche,
**dadurch gekennzeichnet, daß** der Durchmesser des Polblocks (14) etwa das Dreifache des Durchmessers des Untersuchungsbereichs (2) beträgt.

4. MR-Anordnung nach einem der vorhergehenden Ansprüche,
**dadurch gekennzeichnet, daß** die obere Jochplatte (10) eine zentrale Öffnung (17) aufweist insbesondere zum Einbringen weiterer Geräte in den Innenraum (13).

5. MR-Anordnung nach einem der vorhergehenden Ansprüche,
**dadurch gekennzeichnet, daß** die Jochwand (12) aus mehreren voneinander beabstandeten und in gleichen Abständen vom Untersuchungsbereich (2) angeordneten Eisenpfeilern (121, 122, ..., 128) besteht.

6. MR-Anordnung nach einem der vorhergehenden Ansprüche,
**dadurch gekennzeichnet, daß** der Polblock (14) eine zentral im Innern in vertikaler Richtung verlaufende Bohrung (19) aufweist.

7. MR-Anordnung nach einem der vorhergehenden Ansprüche,
**dadurch gekennzeichnet, daß** die Spule (8) supraleitende Eigenschaften aufweist.

## Claims

1. An MR device which includes a main field magnet system (7) which generates a steady magnetic field in an examination zone and comprises:
a) a magnetizable upper yoke plate (10) which is arranged above the examination zone (2),
b) a magnetizable lower yoke plate (11) which is arranged below the examination zone (2),
c) a magnetizable yoke wall (12) which interconnects the two yoke plates (10, 11) and encloses an inner space (13) in conjunction with the yoke plates (10, 11),
**characterized in that** there provided
d) a single coil (8) which is arranged between the examination zone (2) and the upper yoke plate (10), and
e) a single magnetizable pole block (14) which is arranged between the examination zone (2) and the lower yoke plate (11),
and **characterized in that** the ring-shaped coil (8) has a diameter of at least two meters and is arranged symmetrically with respect to a symmetry axis (18) which extends through the examination zone (2) in such a manner that a patient (1) present in the examination zone (2) is freely accessible from the sides and from above.

2. An MR device as claimed in Claim 1,
**characterized in that** the distance between the horizontal central plane (16) of the coil (8) and the upper side (15) of the pole block (14) corresponds to approximately half the radius of the coil (8).

3. An MR device as claimed in any one of the preceding Claims,
**characterized in that** the diameter of the pole block (14) amounts to approximately three times the diameter of the examination zone (2).

4. An MR device as claimed in any one of the preceding Claims,
**characterized in that** the upper yoke plate (10) is provided with a central opening (17) which serves notably for introducing further apparatus into the inner space (13).

5. An MR device as claimed in any one of the preceding Claims,
**characterized in that** the yoke wall (12) consists of a number of iron pillars (121, 122, ..., 128) which are arranged at a distance from one another and at equal distances from the examination zone (2).

6. An MR device as claimed in any one of the preceding Claims,
**characterized in that** at the center of the pole block (14) there is provided a bore (19) which extends in the vertical direction.

7. An MR device as claimed in any one of the preceding Claims, **characterized in that** the coil (8) has superconducting properties.

## Revendications

1. Appareil de résonance magnétique avec un dispositif magnétique de champ de base (7) produisant un champ magnétique stationnaire dans une zone d'examen comprenant
a) une plaque de culasse (10) supérieure magnétisable disposée au-dessus de la zone d'examen,
b) une plaque de culasse (11) inférieure magnétisable disposée en dessous de la zone d'examen (2),
c) une paroi de culasse (2) magnétisable reliant les deux plaques de culasse (10,11) qui forme un espace intérieur (13) avec les plaques de culasse (10, 11),
**caractérisé par**
d) une bobine (8) unique disposée entre la zone d'examen (2) et la plaque de culasse supérieure (10) et
e) un bloc polaire (14) unique magnétisable disposé entre la zone d'examen (2) et la plaque de culasse inférieure (11),
et **caractérisé en ce que**
la bobine (8) circulaire présente un diamètre d'au moins deux mètres et est disposée symétriquement à un axe de symétrie (18) s'étendant verticalement par la zone d'examen de telle sorte qu'un patient (1) se trouvant dans la zone d'examen (2) soit accessible librement par le côté et par le haut.

2. Appareil de résonance magnétique selon l'une des revendications 1 ou 2,
**caractérisé en ce que** la distance entre le plan médian horizontal (16) de la bobine (8) et la face supérieure (15) du bloc polaire (14) correspond approximativement au demi-rayon de la bobine (8).

3. Appareil de résonance magnétique selon l'une des revendications précédentes,
**caractérisé en ce que** le diamètre du bloc polaire (14) s'élève approximativement au triple du diamètre de la zone d'examen (2).

4. Appareil de résonance magnétique selon l'une des revendications précédentes,
**caractérisé en ce que** la plaque de culasse (10) supérieure présente une ouverture centrale (17), en particulier pour l'introduction d'autres appareils dans l'espace intérieur (13).

5. Appareil de résonance magnétique selon l'une des revendications précédentes,
**caractérisé en ce que** la paroi de culasse (12) se compose de plusieurs piliers en fer (121, 122, ..., 128) espacés l'un de l'autre et disposés à égale distance de la zone d'examen (2).

6. Appareil de résonance magnétique selon l'une des revendications précédentes, **caractérisé en ce que** le bloc polaire (14) présente un alésage (19) s'étendant centralement à l'intérieur en direction verticale.

7. Appareil de résonance magnétique selon l'une des revendications précédentes, **caractérisé en ce que** la bobine (8) présente des propriétés supraconductrices.
